# EUROPEAN PATENT APPLICATION

(11) **EP 4 697 089 A1**
(43) Date of publication of application: **18.02.2026**
(21) Application number: 24788797.9
(22) Date of filing: 11.04.2024
(51) Int. Cl.: G02F 1/1345, G02F 1/13, H05K 1/02, H05K 1/03, H05K 1/14

(54) **FLEXIBLE WIRING SUBSTRATE UNIT AND LIGHT CONTROL UNIT**

(30) Priority: 11.04.2023 JP 2023064232; 11.04.2023 JP 2023064233
(71) Applicant: Toppan Holdings Inc., Tokyo 110-0016 (JP)
(72) Inventor: TSUJI, Masaki, Tokyo 110-0016 (JP)
(74) Representative: TBK
(86) International application number: PCT/JP2024/014671
(87) International publication number: WO 2024/214775

(57) **Abstract**

A flexible wiring board unit (12) includes: a first flexible wiring board (12A) extending in a first direction (D1); a second flexible wiring board (12B) extending in the first direction; and a third flexible wiring board (12C) extending in a second direction (D2) and configured to be connected to the first flexible wiring board and the second flexible wiring board, the second direction intersecting the first direction.

## Description

### [Technical Field]

The present disclosure relates to flexible wiring board units and light control units.

### [Background Art]

A light control sheet includes two transparent conductive sheets and a light control layer sandwiched between the two transparent conductive sheets. A first transparent conductive sheet is provided with a first electrode terminal exposed from the light control layer and a second transparent conductive sheet. A second transparent conductive sheet is provided with a second electrode terminal exposed from the light control layer and the first transparent conductive sheet. The electrode terminal included in each transparent conductive sheet is disposed at an edge of the light control sheet. Each electrode terminal is bonded to one of bonded terminals included in a flexible wiring board (see e.g., PTL 1). As a voltage is applied across the two transparent conductive sheets through the flexible wiring board, the diffuse transmittance of the light control layer changes from that before the application of the voltage.

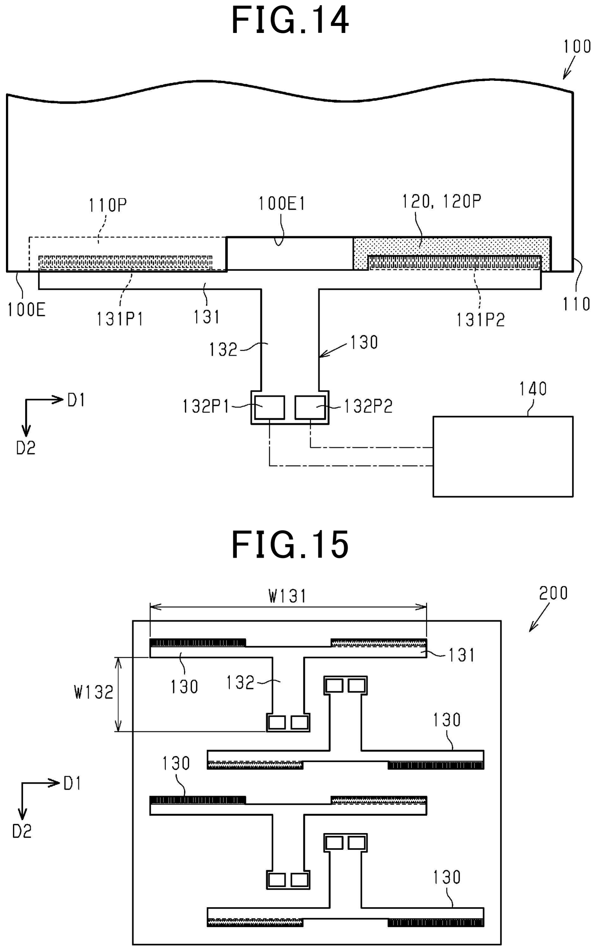

For example, as shown in Fig. 14, a light control sheet 100 includes a first transparent conductive sheet 110, a second transparent conductive sheet 120, and a light control layer disposed between the first transparent conductive sheet 110 and the second transparent conductive sheet 120. In Fig. 14, the first transparent conductive sheet 110 is located on the front side of the second transparent conductive sheet 120 in the drawing. In Fig. 14, for convenience of description of the shape of the respective transparent conductive sheets, the first transparent conductive sheet 110 is indicated by the bold line and the second transparent conductive sheet 120 is indicated by the thin line.

As indicated by the dotted line in Fig. 14, the first transparent conductive sheet 110 includes a first terminal 110P exposed from the second transparent conductive sheet 120 and the light control layer. The first terminal 110P is externally exposed from the light control sheet 100 when viewed from the back toward the front of Fig. 14. The second transparent conductive sheet 120 is a dotted portion in Fig. 14, and includes a second terminal 120P exposed from the first transparent conductive sheet 110 and the light control layer. The second terminal 120P is externally exposed from the light control sheet 100 when viewed from the front toward the back of Fig. 14.

The light control sheet 100 has an edge 100E that extends in a first direction D1. The first terminal 110P and the second terminal 120P are arranged in the first direction D1 at the edge 100E. The edge 100E is partially notched to form a notch 100E1 between the first terminal 110P and the second terminal 120P.

The light control sheet 100 is connected to an external power source 140 via a flexible wiring board 130. The flexible wiring board 130 is a flexible printed circuit (FPC).. The flexible wiring board 130 includes a first portion 131 and a second portion 132. The first portion 131 extends in the first direction D1. The second portion 132 extends, from the center of the first portion 131 in the first direction D1, toward the outside of the light control sheet 100 in a second direction D2 perpendicular to the first direction D1. The flexible wiring board 130 has a substantially T-shaped outline.

The first portion 131 includes a first bonded terminal 131P1 and a second bonded terminal 131P2. The first bonded terminal 131P1 is disposed on a first side of the first portion 131 in the first direction D1, and the second bonded terminal 131P2 is disposed on a second side of the first portion 131 in the first direction D1. The first bonded terminal 131P1 is externally exposed from the flexible wiring board 130 when viewed from the front toward the back of Fig. 14. The first bonded terminal 131P1 is electrically connected to the first terminal 110P. The second bonded terminal 131P2 is externally exposed from the flexible wiring board 130 when viewed from the back toward the front of the Fig. 14. The second bonded terminal 131P2 is electrically connected to the second terminal 120P.

The second portion 132 includes a first power supply terminal 132P1 and a second power supply terminal 132P2. The first power supply terminal 132P1 and the second power supply terminal 132P2 are disposed at the end of the second portion 132 in the second direction D2. The first power supply terminal 132P1 and the second power supply terminal 132P2 are externally exposed from the flexible wiring board 130 when viewed from the front toward the back of Fig. 14. The first power supply terminal 132P1 is electrically connected to the first bonded terminal 131P1 inside the flexible wiring board 130. The second power supply terminal 132P2 is electrically connected to the second bonded terminal 131P2 inside the flexible wiring board 130. The first power supply terminal 132P1 and the second power supply terminal 132P2 are electrically connected to the external power supply 140. The external power supply 140 applies a voltage across the first transparent conductive sheet 110 and the second transparent conductive sheet 120 via the flexible wiring board 130. This causes the light control layer to change the diffuse transmittance from that before the application of the voltage.

### [Citation List]

### [Patent Literature]

PTL 1: JP 2020-38265 A

### [Summary of Invention]

### [Technical Problem]

As shown in Fig. 15, in production of flexible wiring boards 130, a plurality of flexible wiring boards 130 are arranged on a laminate sheet 200. The laminate sheet 200 may include, for example, two resin sheets and a conductor sandwiched between the two resin sheets. In the example shown in Fig. 15, a plurality of flexible wiring boards 130 are arranged in the second direction D2 with the orientation of adjacent flexible wiring boards 130 in the second direction D2 alternately reversed 180 degrees.

In production of flexible wiring boards 130, the ratio of the area used for the flexible wiring boards 130 to the total area of the laminate sheet 200 is small, resulting in poor yield, and therefore it is required to improve the efficiency of arranging the flexible wiring boards on the laminate sheet. In particular, as the light control sheet 100 increases in size, the larger the width W131 of the first portion 131 in the first direction D1, the smaller the ratio of the area used for the flexible wiring boards 130 to the area of the laminate sheet 200. Similarly, the larger the width W132 of the second portion 132 in the second direction D2, the smaller the ratio of the area used for the flexible wiring boards 130 to the total area of the laminate sheet 200.

### [Solution to Problem]

A flexible wiring board unit for solving the above problem includes: a first flexible wiring board extending in a first direction; a second flexible wiring board extending in the first direction; and a third flexible wiring board extending in a second direction and configured to be connected to the first flexible wiring board and the second flexible wiring board, the second direction intersecting the first direction. The first flexible wiring board includes a first bonding terminal bonded to a first connection target, and the second flexible wiring board includes a second bonding terminal bonded to a second connection target. The third flexible wiring board includes: a first connection terminal located at a first end in the second direction, the first connection terminal being connected to the first bonding terminal; a second connection terminal located at the first end in the second direction, the second connection terminal being insulated from the first connection terminal and connected to the second bonding terminal; a first power supply terminal located at a second end in the second direction, the first power supply terminal being electrically connected to the first connection terminal; and a second power supply terminal located at the second end in the second direction, the second power supply terminal being insulated from the first power supply terminal and electrically connected to the second connection terminal.

A flexible wiring board unit for solving the above problem includes: a first flexible wiring board extending in a first direction; a second flexible wiring board extending in the first direction; and a third flexible wiring board extending in a second direction and disposed away from the first flexible wiring board and the second flexible wiring board, the second direction intersecting the first direction. The first flexible wiring board includes a first bonding terminal bonded to a first connection target, and the second flexible wiring board includes a second bonding terminal bonded to a second connection target. The third flexible wiring board includes: a first connection terminal located at a first end in the second direction, the first connection terminal being bonded to the first connection target; a second connection terminal located at the first end in the second direction, the second connection terminal being insulated from the first connection terminal and bonded to the second connection target; a first power supply terminal located at a second end in the second direction, the first power supply terminal being electrically connected to the first connection terminal; and a second power supply terminal located at the second end in the second direction, the second power supply terminal being insulated from the first power supply terminal and electrically connected to the second connection terminal.

A light control unit for solving the above problem includes the flexible wiring board unit described above and a light control sheet. The light control sheet includes: a first transparent conductive sheet including a first transparent electrode layer including a first electrode terminal; a second transparent conductive sheet including a second transparent electrode layer including a second electrode terminal; and a light control layer disposed between the first transparent conductive sheet and the second transparent conductive sheet. The first electrode terminal and the second electrode terminal are arranged in the first direction at respective edges of the light control sheet extending in the first direction. The first bonding terminal is electrically conductively bonded to the first electrode terminal, the second bonding terminal is electrically conductively bonded to the second electrode terminal, and the first connection terminal and the second connection terminal are connected to an external power supply.

A light control unit for solving the above problem includes the flexible wiring board unit described above and a light control sheet. The light control sheet includes: a first transparent conductive sheet including a first transparent electrode layer including a first electrode terminal; a second transparent conductive sheet including a second transparent electrode layer including a second electrode terminal; and a light control layer disposed between the first transparent conductive sheet and the second transparent conductive sheet. The first electrode terminal and the second electrode terminal are arranged in the first direction at respective edges of the light control sheet extending in the first direction. The first bonding terminal is electrically conductively bonded to the first electrode terminal, and the second bonding terminal is electrically conductively bonded to the second electrode terminal. The first connection terminal is located away from the first bonding terminal, and electrically conductively bonded to the first electrode terminal in a state in which the first bonding terminal is located between the light control layer and the first connection terminal in the second direction. The second connection terminal is located away from the second bonding terminal, and electrically conductively bonded to the second electrode terminal in a state in which the second bonding terminal is located between the light control layer and the second connection terminal in the second direction. The first connection terminal and the second connection terminal are connected to an external power supply.

### [Advantageous Effects of Invention]

According to the present disclosure, the yield in producing flexible wiring boards can be increased.

### [Brief Description of Drawings]

Fig. 1 is a plan view of a light control sheet to which a flexible wiring board of a first embodiment is attached.
Fig. 2 is an enlarged plan view of a part of the flexible wiring board attached to the light control sheet shown in Fig. 1.
Fig. 3 is a cross-sectional view illustrating a structure taken along the line III-III of Fig. 1.
Fig. 4 is a cross-sectional view illustrating a structure taken along the line IV-IV of Fig. 1.
Fig. 5 is an exploded plan view of the flexible wiring board shown in Fig. 1.
Fig. 6 is a cross-sectional view illustrating a structure of a third flexible wiring board taken along the line VI-VI of Fig. 5.
Fig. 7 is a cross-sectional view illustrating a structure of the third flexible wiring board taken along the line VII-VII of Fig. 5.
Fig. 8 is a cross-sectional view illustrating a structure of a first flexible wiring board taken along the line VIII-VIII of Fig. 5.
Fig. 9 is a plan view illustrating a laminate sheet on which a plurality of third flexible wiring boards are arranged.
Fig. 10 is a plan view illustrating a laminate sheet on which a plurality of flexible wiring boards functioning as a first flexible wiring board or a second flexible wiring board are arranged.
Fig. 11 is a plan view of a light control sheet to which a flexible wiring board of a second embodiment is attached.
Fig. 12 is an enlarged plan view of a part of the flexible wiring board attached to the light control sheet shown in Fig. 11.
Fig. 13 is an exploded plan view of a flexible wiring board unit shown in Fig. 11.
Fig. 14 is a plan view of a light control sheet to which a conventional flexible wiring board is attached.
Fig. 15 is a plan view illustrating a laminate sheet on which a plurality of flexible wiring boards are arranged in the conventional manufacture of a flexible wiring board.

### [Description of Embodiments]

### [First Embodiment]

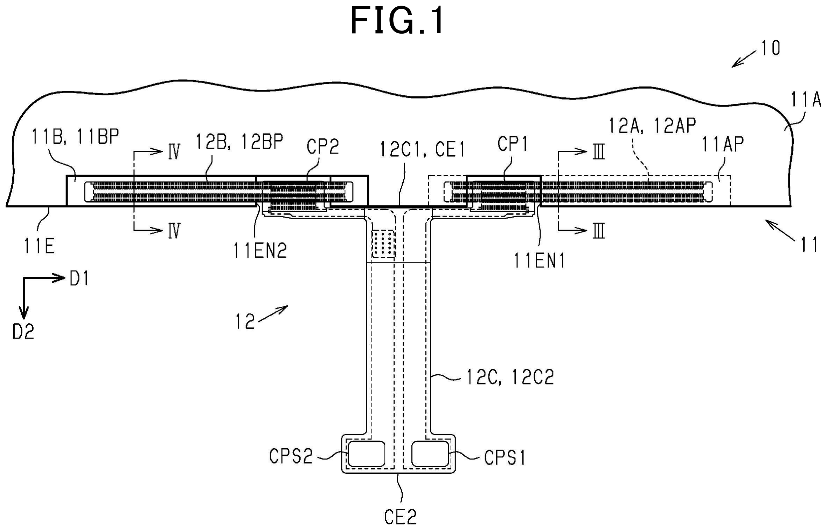

With reference to Figs. 1 to 10, a first embodiment of a flexible wiring board unit and a light control unit will be described.

### [Light Control Unit]

With reference to Figs. 1 to 4, a light control unit will be described.

As shown in Fig. 1, a light control unit 10 includes a light control sheet 11 and a flexible wiring board unit 12. The light control sheet 11 has an edge 11E that extends in the first direction D1. The flexible wiring board unit 12 is connected to the edge 11E.

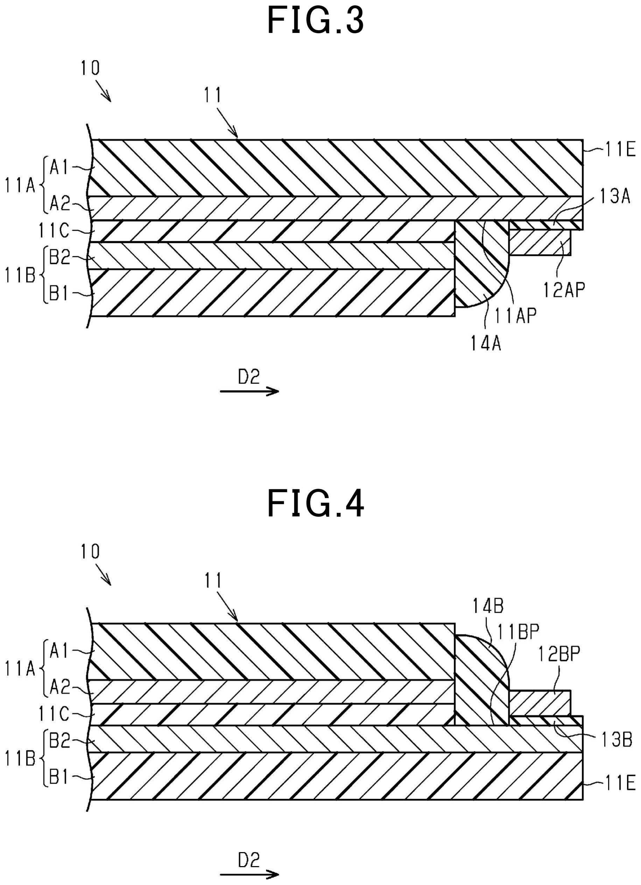

The light control sheet 11 includes a first transparent conductive sheet 11A having a first electrode terminal 11AP and a second transparent conductive sheet 11B having a second electrode terminal 11BP. The first electrode terminal 11AP is an example of a first connection target and the second electrode terminal 11BP is an example of a second connection target. In Fig. 1, the first transparent conductive sheet 11A is located on the front side of the second transparent conductive sheet 11B in the drawing. In Fig. 1, the second transparent conductive sheet 11B is located on the rear side of the first transparent conductive sheet 11A in the drawing. A light control layer 11C (see Fig. 3) is located between the first transparent conductive sheet 11A and the second transparent conductive sheet 11B.

The light control sheet 11 divides a space in which the light control sheet 11 is provided into two spaces. In Fig. 1, of the two spaces divided by the light control sheet 11, the space in contact with the first transparent conductive sheet 11A is a first space. In Fig. 1, of the two spaces divided by the light control sheet 11, the space in contact with the second transparent conductive sheet 11B is a second space. The first space is located on the front side of the second space in the drawing. The second space is located on the rear side of the first space in the drawing.

The first electrode terminal 11AP is a portion of the first transparent conductive sheet 11A exposed from the second transparent conductive sheet 11B and the light control layer 11C. The first electrode terminal 11AP faces the second space located on the rear side of the light control sheet 11 in the drawing. The second electrode terminal 11BP is a portion of the second transparent conductive sheet 11B exposed from the first transparent conductive sheet 11A and the light control layer 11C. The second electrode terminal 11BP faces the first space located on the front side of the light control sheet 11 in the drawing. The first electrode terminal 11AP and the second electrode terminal 11BP are arranged at an interval in the first direction D1.

The edge 11E has a first notch 11EN1 and a second notch 11EN2. Each of the notches 11EN1 and 11EN2 is a recess in which a portion of the outline of the light control sheet 11 included in the edge 11E is recessed toward the inside of the light control sheet 11. The first notch 11EN1 is located in the first electrode terminal 11AP, and the second notch 11EN2 is located in the second electrode terminal 11BP. In the first direction D1, the first electrode terminal 11AP is divided into two by the first notch 11EN1, and the second electrode terminal 11BP is divided into two by the second notch 11EN2.

The flexible wiring board unit 12 includes a first flexible wiring board 12A extending in the first direction D1, a second flexible wiring board 12B extending in the first direction D1, and a third flexible wiring board 12C extending in the second direction D2. The second direction D2 is a direction intersecting the first direction D1. An example of the second direction D2 is a direction perpendicular to the first direction D1. Each of the flexible wiring boards 12A, 12B and 12C is a flexible printed circuit board (FPC).

The first flexible wiring board 12A includes a first bonding terminal 12AP. The first bonding terminal 12AP has a length that extends substantially the entire length of the first flexible wiring board 12A in the first direction D1. The first bonding terminal 12AP is located on the second space side of the first electrode terminal 11AP. The first bonding terminal 12AP is bonded and electrically connected to the first electrode terminal 11AP while facing the first electrode terminal 11AP. The first bonding terminal 12AP has a length that extends substantially the entire length of the first electrode terminal 11AP in the first direction D1.

The second flexible wiring board 12B includes a second bonding terminal 12BP. The second bonding terminal 12BP has a length that extends substantially the entire length of the second flexible wiring board 12B in the first direction D1. The second bonding terminal 12BP is located on the first space side of the second electrode terminal 11BP. The second bonding terminal 12BP is bonded and electrically connected to the second electrode terminal 11BP while facing the second electrode terminal 11BP. The second bonding terminal 12BP has a length that extends substantially the entire length of the second electrode terminal 11BP in the first direction D1.

The first flexible wiring board 12A and the second flexible wiring board 12B are arranged at an interval in the first direction D1 at the edge 11E of the light control sheet 11.

The third flexible wiring board 12C has a substantially T-shaped outline. The third flexible wiring board 12C has a first end CE1 and a second end CE2 in the second direction D2. In the third flexible wiring board 12C, a portion extending in the first direction D1 is a first portion 12C1 and a portion extending in the second direction D2 is a second portion 12C2. The second portion 12C2 is located between the first flexible wiring board 12A and the second flexible wiring board 12B in the first direction D1.

The width of the second portion 12C2 in the first direction D1 is smaller than the gap between the first flexible wiring board 12A and the second flexible wiring board 12B in the first direction D1. The width of the first portion 12C1 in the first direction D1 is less than twice the width of the first flexible wiring board 12A in the first direction D1, preferably 1.5 times or less the width of the first flexible wiring board 12A, and more preferably less than or equal to the width of the first flexible wiring board 12A. In the present embodiment, the width of the first portion 12C1 in the first direction D1 is less than the width of the first flexible wiring board 12A.

The first portion 12C1 is located at the first end CE1 in the second direction D2. The first portion 12C1 includes a first connection terminal CP1 and a second connection terminal CP2. The first connection terminal CP1 is located at the first end CE1 and connected to the first bonding terminal 12AP. The second connection terminal CP2 is located at the first end CE1. The second connection terminal CP2 is insulated from the first connection terminal CP1 and connected to the second bonding terminal 12BP. The first connection terminal CP1 and the second connection terminal CP2 are arranged at an interval in the first direction D1.

The first connection terminal CP1 is connected to the first bonding terminal 12AP in the first notch 11EN1. Therefore, the first connection terminal CP1 is in contact with the first bonding terminal 12AP directly or via an adhesive, but is not in contact with the first electrode terminal 11AP. The first bonding terminal 12AP is connected to the first electrode terminal 11AP in a portion other than the portion located in the first notch 11EN1.

The first connection terminal CP1 of the third flexible wiring board 12C is configured to be connected to a portion of the first flexible wiring board closer to the second flexible wiring board 12B than the center of the first flexible wiring board 12A is in the first direction D1. The third flexible wiring board 12C can be prevented from increasing in size compared to the case where the first connection terminal CP1 of the third flexible wiring board 12C is configured to be connected to the first flexible wiring board 12A at a position farther from the second flexible wiring board 12B than the center of the first flexible wiring board 12A is in the first direction D1. Therefore, it is possible to improve the efficiency of arranging the third flexible wiring board 12C. From the viewpoint of improving the arrangement efficiency, it is preferred that the first connection terminal CP1 is connected to an end of the first flexible wiring board 12A at a shorter distance from the second flexible wiring board 12B in the first direction D1.

The second connection terminal CP2 is connected to the second bonding terminal 12BP in the second notch 11EN2. Therefore, the second connection terminal CP2 is in contact with the second bonding terminal 12BP directly or via an adhesive, but is not in contact with the second electrode terminal 11BP. The second bonding terminal 12BP is connected to the second electrode terminal 11BP in a portion other than the portion located in the second notch 11EN2.

The second connection terminal CP2 of the third flexible wiring board 12C is configured to be connected to a portion of the second flexible wiring board closer to the first flexible wiring board 12A than the center of the second flexible wiring board 12B is in the first direction D1. The third flexible wiring board 12C can be prevented from increasing in size compared to the case where the second connection terminal CP2 of the third flexible wiring board 12C is configured to be connected to the second flexible wiring board 12B at a position farther from the first flexible wiring board 12A than the center of the second flexible wiring board 12B is in the first direction D1. Therefore, it is possible to improve the efficiency of arranging the third flexible wiring board 12C. From the viewpoint of improving the arrangement efficiency, it is preferred that the second connection terminal CP2 is connected to an end of the second flexible wiring board 12B at a shorter distance from the first flexible wiring board 12A in the first direction D1.

The third flexible wiring board 12C includes a first power supply terminal CPS1 and a second power supply terminal CPS2. The first power supply terminal CPS1 is located at the second end CE2 and is electrically connected to the first connection terminal CP1. The second power supply terminal CPS2 is located at the second end CE2. The second power supply terminal CPS2 is insulated from the first power supply terminal CPS1 and electrically connected to the second connection terminal CP2. The first power supply terminal CPS1 and the second power supply terminal CPS2 are arranged at an interval in the first direction D1. In the first direction D1, the distance between the first power supply terminal CPS1 and the second power supply terminal CPS2 is smaller than the distance between the first connection terminal CP1 and the second connection terminal CP2.

The first power supply terminal CPS1 and the second power supply terminal CPS2 are connected to an external power supply. Since a voltage is applied to the first connection terminal CP1 via the first power supply terminal CPS1, a voltage is applied from the first connection terminal CP1 to the first bonding terminal 12AP and then to the first transparent conductive sheet 11A. Since a voltage is applied to the second connection terminal CP2 via the second power supply terminal CPS2, a voltage is applied from the second connection terminal CP2 to the second bonding terminal 12BP and then to the second transparent conductive sheet 11B.

The external power supply applies a voltage across the first transparent conductive sheet 11A and the second transparent conductive sheet 11B of the light control sheet 11 via the flexible wiring board unit 12. As a result, the diffuse transmittance of the light control layer 11C changes between before and after the voltage is applied, and thus the diffuse transmittance of the light control sheet 11 changes.

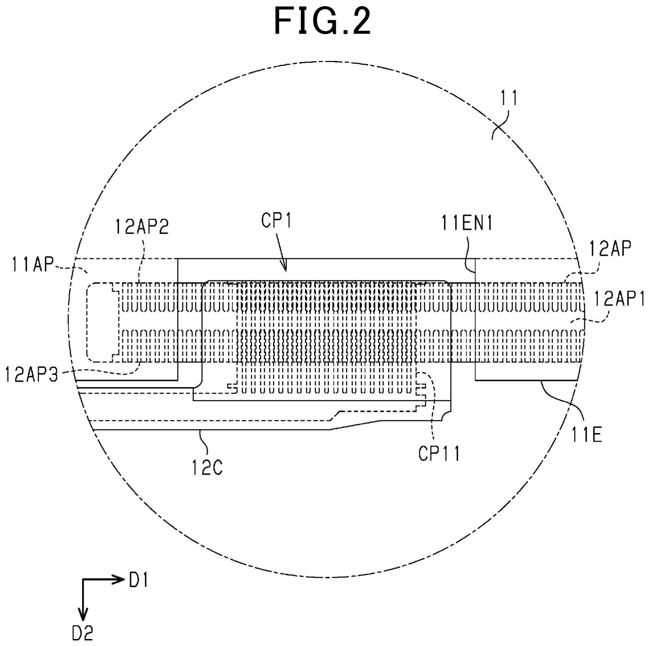

Fig. 2 shows an enlarged view of a part of the first bonding terminal 12AP and the first connection terminal CP1 connected to the first bonding terminal 12AP. In the flexible wiring board unit 12, the position of the second bonding terminal 12BP is different from the position of the first bonding terminal 12AP, while the structure of the second bonding terminal 12BP is the same as the structure of the first bonding terminal 12AP. Further, in the third flexible wiring board 12C, the position of the second connection terminal CP2 is different from the position of the first connection terminal CP1, while the structure of the second connection terminal CP2 is the same as the structure of the first connection terminal CP1. Therefore, in the following description, the structure of the first bonding terminal 12AP and the structure of the first connection terminal CP1 will be described in detail, but the structure of the second bonding terminal 12BP and the structure of the second connection terminal CP2 will not be described.

As shown in Fig. 2, the first bonding terminal 12AP includes a main body portion 12AP1, a first comb-like electrode portion 12AP2, and a second comb-like electrode portion 12AP3. The main body portion 12AP1 has a strip shape extending in the first direction D1. The first comb-like electrode portion 12AP2 is located at the first end of the main body portion 12AP1 in the second direction D2 and has a comb-like shape with a series of teeth extending in the second direction D2. In the example shown in Fig. 2, a plurality of teeth are arranged at equal intervals in the first direction D1. The second comb-like electrode portion 12AP3 is located at the second end of the main body portion 12AP1 in the second direction D2 and has a comb-like shape with a series of teeth extending in the second direction D2. In the example shown in Fig. 2, a plurality of teeth are arranged at equal intervals in the first direction D1.

In the example shown in Fig. 2, in the first direction D1, the distance between the teeth of the first comb-like electrode portion 12AP2 is equal to the distance between the teeth of the second comb-like electrode portion 12AP3. Each tooth included in the first comb-like electrode portion 12AP2 is aligned with one tooth included in the second comb-like electrode portion 12AP3 along the same straight line in the second direction D2.

The first connection terminal CP1 includes a comb-like electrode portion CP11. The comb-like electrode portion CP11 has a comb-like shape with a plurality of teeth extending in the second direction D2, and is configured to be in contact with the first comb-like electrode portion 12AP2 and the second comb-like electrode portion 12AP3. In the example shown in Fig. 2, the plurality of teeth included in the comb-like electrode portion CP11 are arranged at equal intervals in the first direction D1.

In the example shown in Fig. 2, in the first direction D1, the distance between the teeth of the comb-like electrode portion CP11 is equal to the distance between the teeth of the first comb-like electrode portion 12AP2 and the distance between the teeth of the second comb-like electrode portion 12AP3. The first connection terminal CP1 may be aligned with the first bonding terminal 12AP such that each tooth included in the first connection terminal CP1, each tooth included in the first comb-like electrode portion 12AP2, and each tooth included in the second comb-like electrode portion 12AP3 are aligned in the same straight line.

According to the flexible wiring board unit 12, a conductive adhesive used when connecting the first connection terminal CP1 to the first bonding terminal 12AP can easily spread in the first direction D1 through the main body portion 12AP1 of the first bonding terminal 12AP. Therefore, it is easy to apply the adhesive to the first bonding terminal 12AP, ensuring conductivity between the first bonding terminal 12AP and the first connection terminal CP1.

In the second direction D2, the length of each tooth included in the comb-like electrode portion CP11 is longer than the sum of the length of each respective tooth included in the first comb-like electrode portion 12AP2 and the length of each respective tooth included in the second comb-like electrode portion 12AP3. In the example shown in Fig. 2, all the teeth included in the comb-like electrode portion CP11 have the same length. Further, all the teeth included in the first comb-like electrode portion 12AP2 have the same length, and all the teeth included in the second comb-like electrode portion 12AP3 have the same length. The length of each tooth included in the first comb-like electrode portion 12AP2 is equal to the length of each tooth included in the second comb-like electrode portion 12AP3.

When the first connection terminal CP1 is connected to the first bonding terminal 12AP, the teeth of the first connection terminal CP1 can be in contact with both the teeth of the first comb-like electrode portion 12AP2 and the teeth of the second comb-like electrode portion 12AP3. Therefore, it is possible to expand the contact area between the first connection terminal CP1 and the first bonding terminal 12AP compared to the case where the first connection terminal CP1 is in contact only with the teeth of one of the comb-like electrode portions 12AP2 and 12AP3 of the first bonding terminal 12AP.

As shown in Fig. 3, the light control sheet 11 includes the first transparent conductive sheet 11A, the second transparent conductive sheet 11B and the light control layer 11C. The first transparent conductive sheet 11A includes a first transparent substrate A1 and a first transparent electrode layer A2. The second transparent conductive sheet 11B includes a second transparent substrate B1 and a second transparent electrode layer B2. The light control layer 11C is disposed between the first transparent electrode layer A2 and the second transparent electrode layer B2. In the light control sheet 11, the first transparent substrate A1, the first transparent electrode layer A2, the light control layer 11C, the second transparent electrode layer B2 and the second transparent substrate B1 are laminated in this order.

The first transparent substrate A1 and the second transparent substrate B1 have optical transparency to visible light and electrical insulating properties. The material forming the first transparent substrate A1 and the second transparent substrate B1 is an organic polymer compound or an inorganic polymer compound. An example of the organic polymer compound is at least one selected from the group consisting of polyester, polyacrylate, polycarbonate and polyolefin. An example of the inorganic polymer compound is at least one selected from the group consisting of silicon dioxide, silicon oxynitride and silicon nitride.

The first transparent electrode layer A2 and the second transparent electrode layer B2 have optical transparency to visible light and electrical conductivity. An example of the material for forming the first transparent electrode layer A2 and the second transparent electrode layer B2 is at least one selected from the group consisting of indium tin oxide, fluorine-doped tin oxide, tin oxide, zinc oxide, carbon nanotubes and poly 3,4-ethylenedioxythiophene.

The light control layer 11C changes the diffuse transmittance after a voltage is applied between the first transparent electrode layer A2 and the second transparent electrode layer B2 from the diffuse transmittance before the voltage is applied. An example of the light control layer 11C includes a transparent organic polymer layer and a liquid crystal composition. The transparent organic polymer layer defines voids filled with the liquid crystal composition between the first transparent electrode layer A2 and the second transparent electrode layer B2. The liquid crystal composition fills the voids in the transparent organic polymer layer. The liquid crystal composition includes a liquid crystal compound. An example of the liquid crystal compound is at least one selected from the group consisting of Schiff base compounds, azo compounds, azoxy compounds, biphenyl compounds, terphenyl compounds, benzoic acid ester compounds, tolan compounds, pyrimidine compounds, cyclohexanecarboxylic acid ester compounds, phenylcyclohexane compounds and dioxane compounds.

The type in which the liquid crystal composition is held in the light control layer 11C is one selected from the group consisting of a polymer network type, a polymer dispersion type, and a capsule type. The polymer network type has a transparent three-dimensional mesh polymer network, and holds the liquid crystal composition in the voids in the interconnected mesh. The polymer network is an example of the transparent organic polymer layer. The polymer dispersed type has a large number of isolated voids in the transparent organic polymer layer, and holds the liquid crystal composition in the voids dispersed in the polymer layer. The capsule type holds an encapsulated liquid crystal composition in the transparent organic polymer layer. Note that the liquid crystal composition may contain, in addition to the above-mentioned liquid crystal compound, at least one of a monomer for forming the transparent organic polymer layer, and a dichroic dye. That is, the liquid crystal composition may contain either one of the monomer and the dichroic dye, or may contain both the monomer and the dichroic dye.

The first electrode terminal 11AP is a portion of the first transparent electrode layer A2 exposed from the second transparent conductive sheet 11B and the light control layer 11C. The first bonding terminal 12AP of the first flexible wiring board 12A is electrically conductively bonded to the first electrode terminal 11AP via the first conductive adhesive 13A. An example of the first conductive adhesive 13A may be at least one selected from the group consisting of an anisotropic conductive film (ACF), an anisotropic conductive paste (ACP), an isotropic conductive film (ICF) and an isotropic conductive paste (ICP).

The first electrode terminal 11AP is provided with a first sealing member 14A covering an edge face of the light control layer 11C. The first sealing member 14A is made of an insulating resin. Examples of the material forming the first sealing member 14A include epoxy resins and acrylic resins. The first sealing member 14A is in close contact with the first electrode terminal 11AP while being in close contact with the edge face of the second transparent conductive sheet 11B and the edge face of the light control layer 11C.

As shown in Fig. 4, the second electrode terminal 11BP is a portion of the second transparent electrode layer B2 exposed from the first transparent conductive sheet 11A and the light control layer 11C. The second bonding terminal 12BP of the second flexible wiring board 12B is electrically conductively bonded to the second electrode terminal 11BP via the second conductive adhesive 13B. The second conductive adhesive 13B may be, for example, at least one of the materials for forming the first conductive adhesive 13A.

The second electrode terminal 11BP is provided with a second sealing member 14B covering an edge face of the light control layer 11C. The second sealing member 14B is made of an insulating resin. Examples of the material forming the second sealing member 14B include epoxy resins and acrylic resins. The second sealing member 14B is in close contact with the second electrode terminal 11BP while being in close contact with the edge face of the first transparent conductive sheet 11A and the edge face of the light control layer 11C. The first sealing member 14A and the second sealing member 14B, which cover the edge face of the light control layer 11C, prevents external leakage of the liquid crystal composition from the light control layer 11C and suppresses deterioration of the liquid crystal composition due to acid, moisture, UV light, and the like.

### [Flexible Wiring Board Unit]

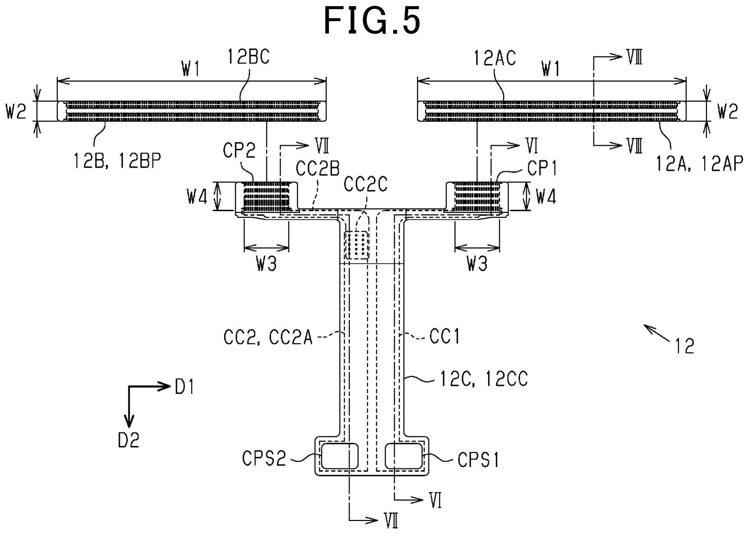

With reference to Figs. 5 to 7, the flexible wiring board unit 12 will be described.

As shown in Fig. 5, in the flexible wiring board unit 12, the first flexible wiring board 12A and the second flexible wiring board 12B are electrically connected to the third flexible wiring board 12C. In the present embodiment, the first flexible wiring board 12A has the same shape as the shape of the second flexible wiring board 12B. Therefore, it is possible to reduce the number of types of flexible wiring boards constituting the flexible wiring board unit 12 compared to the case where the first flexible wiring board 12A has a shape different from that of the second flexible wiring board 12B. Therefore, the burden required for producing the flexible wiring board unit 12 can be reduced. In the following description, the shape of the first flexible wiring board 12A will be described, and the description of the shape of the second flexible wiring board 12B will be omitted.

The first flexible wiring board 12A has a first width W1 in the first direction D1 and a second width W2 in the second direction D2. The first width W1 is greater than the second width W2. The connection terminals CP1 and CP2 of the third flexible wiring board 12C have a third width W3 in the first direction D1 and a fourth width W4 in the second direction D2. The third width W3 is greater than the fourth width W4.

The third width W3 is smaller than the first width W1. The third width W3 may be, for example, 50% or less of the first width W1, and is preferably 30% or less. The second width W2 is smaller than the fourth width W4. The second width W2 may be, for example, 50% or greater of the fourth width W4, and is preferably 80% or greater. The maximum width of the third flexible wiring board 12C in the first direction D1 is less than twice the first width W1 of the first flexible wiring board 12A, preferably 1.5 times or less the first width W1, and more preferably less than or equal to the first width W1.

As described above, the first flexible wiring board 12A includes the first bonding terminal 12AP extending in the first direction D1. The first bonding terminal 12AP is made of a conductor. The first bonding terminal 12AP is preferably formed of a conductor having a lower resistance than the first transparent electrode layer A2. The first bonding terminal 12AP may be made of, for example, copper.

The first flexible wiring board 12A includes a first covering portion 12AC that covers the first bonding terminal 12AP. The first covering portion 12AC is made of an insulator. The first covering portion 12AC may be made of, for example, a resin sheet. The first covering portion 12AC preferably has optical transparency, which allows the first bonding terminal 12AP to be seen from the outside of the first flexible wiring board 12A. The first covering portion 12AC externally exposes a portion of the first bonding terminal 12AP that is connected to the first electrode terminal 11AP and a portion that is connected to the first connection terminal CP1. For example, the first covering portion 12AC externally exposes substantially the entire surface of the first bonding terminal 12AP on a side facing the first electrode terminal 11AP and a portion of the surface on a side opposite to that facing the first electrode terminal 11AP.

The second bonding terminal 12BP of the second flexible wiring board 12B is made of a conductor, similarly to the first bonding terminal 12AP. The second bonding terminal 12BP is preferably formed of a conductor having a lower resistance than the second transparent electrode layer B2. The second bonding terminal 12BP may be made of, for example, copper.

The second flexible wiring board 12B includes a second covering portion 12BC that covers the second bonding terminal 12BP, similarly to the first flexible wiring board 12A. The second covering portion 12BC is made of an insulator. The second covering portion 12BC may be made of, for example, a resin sheet. The second covering portion 12BC preferably has optical transparency, which allows the second bonding terminal 12BP to be seen from the outside of the second flexible wiring board 12B. The second covering portion 12BC externally exposes a portion of the second bonding terminal 12BP that is connected to the second electrode terminal 11BP and a portion that is connected to the second connection terminal CP2. For example, the second covering portion 12BC externally exposes substantially the entire surface of the second bonding terminal 12BP on a side facing the second electrode terminal 11BP and a portion of the surface on a side opposite to that facing the second electrode terminal 11BP.

The third flexible wiring board 12C includes a first conductive portion CC1, a second conductive portion CC2 and a third covering portion 12CC. The first conductive portion CC1 has a substantially L-shape. The first conductive portion CC1 includes a first connection terminal CP1 and a first power supply terminal CPS1 at the respective ends in the second direction D2. The first conductive portion CC1 is preferably formed of a conductor having a lower resistance than the first transparent electrode layer A2. The first conductive portion CC1 may be made of, for example, copper.

The second conductive portion CC2 has a substantially L-shape. The second conductive portion CC2 extends in the second direction D2, and is line-symmetrical to the first conductive portion CC1 about an axis of symmetry located between the first conductive portion CC1 and the second conductive portion CC2 in the first direction D1. The second conductive portion CC2 includes a second connection terminal CP2 and a second power supply terminal CPS2 at the respective ends in the second direction D2. The second conductive portion CC2 includes a first portion CC2A and a second portion CC2B. The first portion CC2A includes the second power supply terminal CPS2, and the second portion CC2B includes the second connection terminal CP2. The first portion CC2A and the second portion CC2B are connected to each other at a connecting section CC2C.

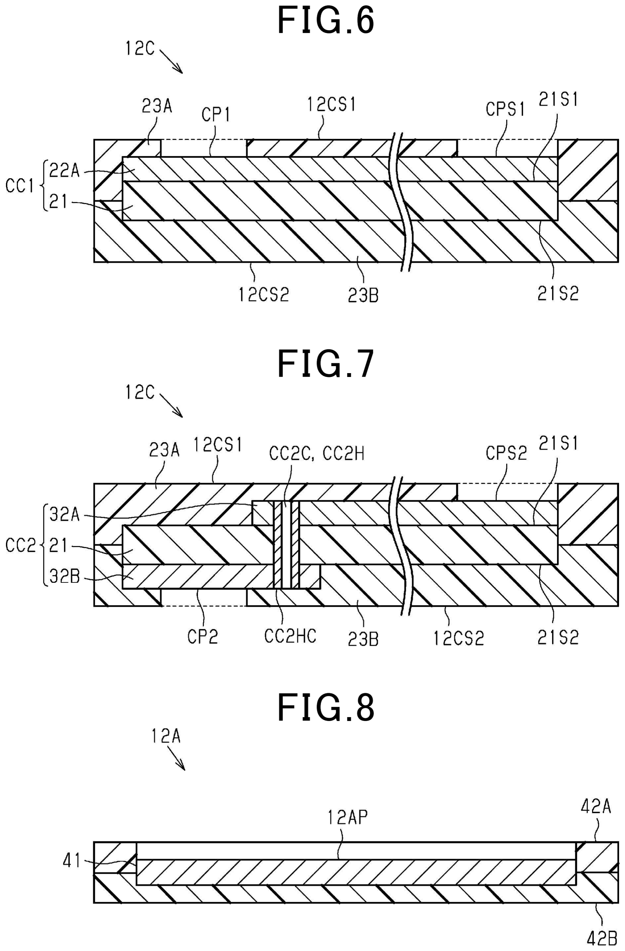

Fig. 6 shows a cross-sectional structure taken along the line VI-VI shown in Fig. 5.

As shown in Fig. 6, the first conductive portion CC1 includes an insulating layer 21 and a first conductive layer 22A. The insulating layer 21 is a sheet made of a synthetic resin. The synthetic resin forming the insulating layer 21 may be, for example, polyimide. The first conductive layer 22A is a metal thin film. The metal thin film may be, for example, a copper thin film. The insulating layer 21 has a first surface 21S1, and a second surface 21S2 facing away from the first surface 21S1. The first conductive layer 22A is disposed on the first surface 21S1.

The third flexible wiring board 12C includes a first cover layer 23A and a second cover layer 23B. The above-mentioned third covering portion 12CC is composed of the first cover layer 23A and the second cover layer 23B. The first cover layer 23A and the second cover layer 23B are sheets made of synthetic resin. The synthetic resin forming each of the cover layers 23A and 23B may be, for example, polyimide.

The second cover layer 23B covers the second surface 21S2 of the insulating layer 21. The first cover layer 23A covers the first conductive layer 22A. The first cover layer 23A has two through holes penetrating the first cover layer 23A in the thickness direction. In the first conductive layer 22A, a portion exposed from the first through hole is the first connection terminal CP1 and a portion exposed from the second through hole is the first power supply terminal CPS1. Therefore, the first connection terminal CP1 and the first power supply terminal CPS1 face in the same direction relative to the insulating layer 21.

Fig. 7 shows a cross-sectional structure taken along the line VII-VII shown in Fig. 5. In Fig. 7, only one through hole included in the connecting section CC2C is shown for convenience of illustration.

As shown in Fig. 7, the second conductive portion CC2 includes the insulating layer 21, a first conductive layer 32A and a second conductive layer 32B. The insulating layer 21 is common to the insulating layer 21 included in the first conductive portion CC1. Each of the conductive layers 32A and 32B is a metal thin film. The metal thin film may be, for example, a copper thin film. In the connecting section CC2C in the second conductive portion CC2, the first conductive layer 32A and the second conductive layer 32B overlap each other with the insulating layer 21 interposed therebetween. On the other hand, in the second conductive portion CC2, in the portion of the first portion CC2A excluding the connecting section CC2C, the second conductive portion CC2 does not include the second conductive layer 32B. In the second conductive portion CC2, in the portion of the second portion CC2B excluding the connecting section CC2C, the second conductive portion CC2 does not include the first conductive layer 32A.

In the second conductive portion CC2, the connecting section CC2C has a through hole CC2H that penetrates the first conductive layer 32A, the insulating layer 21 and the second conductive layer 32B in the thickness direction of the second conductive portion CC2. A conductive layer CC2HC is disposed on the inner peripheral surface that defines the through hole CC2H. The conductive layer CC2HC is a metal thin film. The first conductive layer 32A is electrically connected to the second conductive layer 32B by the conductive layer CC2HC in the through hole CC2H.

The first cover layer 23A covers the first conductive layer 32A and a portion of the first surface 21S1 of the insulating layer 21 where the first conductive layer 32A is not provided. The second cover layer 23B covers the second conductive layer 32B and a portion of the second surface 21S2 of the insulating layer 21 where the second conductive layer 32B is not provided. The second conductive portion CC2 is encompassed within the space defined by the first cover layer 23A and the second cover layer 23B.

In the second conductive portion CC2, the second connection terminal CP2 is a portion of the second conductive layer 32B exposed from the through hole of the second cover layer 23B. In the second conductive portion CC2, the second power supply terminal CPS2 is a portion of the first conductive layer 32A exposed from the through hole of the first cover layer 23A. Therefore, the second connection terminal CP2 and the second power supply terminal CPS2 face away from each other relative to the insulating layer 21.

In other words, the third flexible wiring board 12C includes a first surface 12CS1, and a second surface 12CS2 facing away from the first surface 12CS1 in the thickness direction of the third flexible wiring board 12C. The first surface 12CS1 is a surface of the first cover layer 23A on a side opposite to that in contact with the second cover layer 23B. The second surface 12CS2 is a surface of the second cover layer 23B on a side opposite to that in contact with the first cover layer 23A. The first connection terminal CP1, the first power supply terminal CPS1 and the second power supply terminal CPS2 face the first surface 12CS1, and the second connection terminal CP2 faces the second surface 12CS2. Thus, even when the first bonding terminal 12AP and the second bonding terminal 12BP face away from each other, the first power supply terminal CPS1 and the second power supply terminal CPS2 can be oriented in the same direction by the third flexible wiring board 12C.

Fig. 8 shows a cross-sectional structure of the first flexible wiring board 12A taken along the line VIII-VIII shown in Fig. 5. Further, a cross-sectional structure of the second flexible wiring board 12B in the second direction D2 is the same as the cross-sectional structure of the first flexible wiring board 12A, except that the cross-sectional structure of the first flexible wiring board 12A is shown vertically inverted.

As shown in Fig. 8, the first flexible wiring board 12A includes a conductive layer 41, a first cover layer 42A and a second cover layer 42B. The first bonding terminal 12AP is included in the conductive layer 41. The first cover layer 42A has a through hole penetrating the first cover layer 42A in the thickness direction. The first bonding terminal 12AP is exposed from the through hole of the first cover layer 42A. The second cover layer 42B has a through hole (not shown in Fig. 8) penetrating the second cover layer 42B in the thickness direction. The first connection terminal CP1 of the third flexible wiring board 12C is connected to a portion of the first bonding terminal 12AP exposed from the through hole of the second cover layer 42B.

### [Method for Arranging Flexible Wiring Boards]

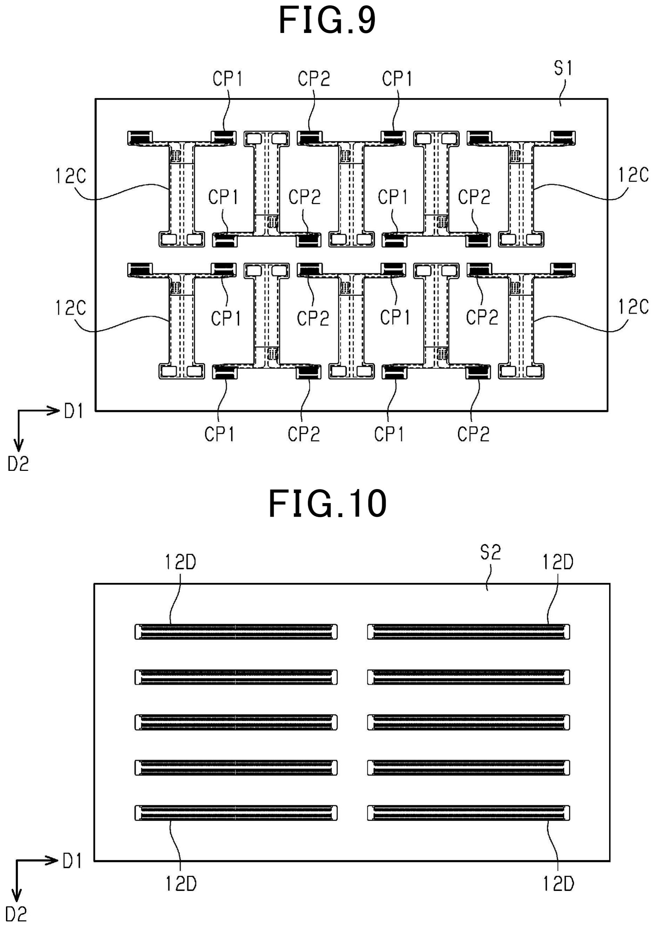

With reference to Figs. 9 and 10, a method for arranging the flexible wiring boards 12A, 12B and 12C will be described.

Fig. 9 shows a first laminate sheet on which a plurality of third flexible wiring boards 12C are arranged.

As shown in Fig. 9, a plurality of third flexible wiring boards 12C are arranged on a first laminate sheet S1. The first laminate sheet S1 includes an insulating layer including the above-mentioned insulating layer 21 for constituting the third flexible wiring board 12C, and conductive layers 22A, 32A and 32B patterned for the respective third flexible wiring boards 12C. The first laminate sheet S1 includes an insulating layer including the first cover layer 23A and an insulating layer including the second cover layer 23B.

In the example shown in Fig. 9, the plurality of third flexible wiring boards 12C are arranged in the first direction D1 and also in the second direction D2. The number of third flexible wiring boards 12C arranged in the first direction D1 and the number of third flexible wiring boards 12C arranged in the second direction D2 in the first laminate sheet S1 can be set according to the size of the first laminate sheet S1 in the first direction D1 and the size of the first laminate sheet S1 in the second direction D2.

As shown in Fig. 9, the third flexible wiring boards 12C adjacent to each other in the first direction D1 are arranged with their orientations in the second direction D2 alternatively reversed. The third flexible wiring boards 12C adjacent to each other in the first direction D1 are arranged such that the first connection terminal CP1 on one third flexible wiring board 12C is aligned with the first connection terminal CP1 on another third flexible wiring board 12C in the second direction D2. Further, the third flexible wiring boards 12C adjacent to each other in the first direction D1 are arranged such that the second connection terminal CP2 on one third flexible wiring board 12C is aligned with the second connection terminal CP2 on another third flexible wiring board 12C in the second direction D2. This can further improve the efficiency in arranging the third flexible wiring boards 12C on the first laminate sheet S1.

Fig. 10 shows a second laminate sheet on which a plurality of flexible wiring boards are arranged. As described above, since the first flexible wiring board 12A and the second flexible wiring board 12B have the same shape, each of the flexible wiring boards arranged on the second laminate sheet can function as the first flexible wiring board 12A or as the second flexible wiring board 12B.

As shown in Fig. 10, a plurality of flexible wiring boards 12D are arranged on a second laminate sheet S2. The second laminate sheet S2 includes a conductive layer 41 patterned for each flexible wiring board 12D, an insulating layer including the first cover layer 42A and an insulating layer including the second cover layer 42B. The flexible wiring board 12D has a strip shape extending in the first direction D1. In the second laminate sheet S2, the plurality of flexible wiring boards 12D are arranged in the first direction D1 and also in the second direction D2. The number of flexible wiring boards 12D arranged in the first direction D1 and the number of flexible wiring boards 12D arranged in the second direction D2 can be set according to the size of the second laminate sheet S2 in the first direction D1 and the size of the second laminate sheet S2 in the second direction D2.

Thus, according to the flexible wiring board unit 12 of the present disclosure, the first flexible wiring boards 12A and the second flexible wiring boards 12B extending in the first direction D1 and the third flexible wiring boards 12C extending in the second direction D2 can be arranged on separate laminate sheets. This can improve the proportion of the flexible wiring boards 12A, 12B and 12C in the laminate sheet. As a result, it is possible to increase the yield in producing the flexible wiring boards 12A, 12B and 12C.

As described above, according to the first embodiment of the flexible wiring board unit and the light control unit, the following effects can be obtained.
(1-1) The first flexible wiring boards 12A and the second flexible wiring boards 12B extending in the first direction D1 and the third flexible wiring boards 12C extending in the second direction D2 can be arranged on separate laminate sheets. This can improve the proportion of the flexible wiring boards 12A, 12B and 12C in the laminate sheet. As a result, it is possible to increase the yield in producing the flexible wiring boards 12A, 12B and 12C.
(1-2) A conductive adhesive used when connecting the first connection terminal CP1 to the first bonding terminal 12AP can easily spread in the first direction D1 through the main body portion 12AP1 of the first bonding terminal 12AP. Therefore, it is easy to apply the adhesive to the first bonding terminal 12AP, ensuring conductivity between the first bonding terminal 12AP and the first connection terminal CP1.
(1-3) When the first connection terminal CP1 is connected to the first bonding terminal 12AP, the teeth of the first connection terminal CP1 can be in contact with both the teeth of the first comb-like electrode portion 12AP2 and the teeth of the second comb-like electrode portion 12AP3. Therefore, it is possible to expand the contact area between the first connection terminal CP1 and the first bonding terminal 12AP compared to the case where the first connection terminal CP1 is in contact only with the teeth of one of the comb-like electrode portions 12AP2 and 12AP3 of the first bonding terminal 12AP.
(1-4) It is possible to reduce the number of types of flexible wiring boards constituting the flexible wiring board unit 12 compared to the case where the first flexible wiring board 12A has a shape different from that of the second flexible wiring board 12B. Therefore, the burden required for producing the flexible wiring board unit 12 can be reduced.
(1-5) Even when the first bonding terminal 12AP and the second bonding terminal 12BP face away from each other, the first power supply terminal CPS1 and the second power supply terminal CPS2 can be oriented in the same direction by the third flexible wiring board 12C.
(1-6) The third flexible wiring board 12C can be prevented from increasing in size compared to the case where the first connection terminal CP1 of the third flexible wiring board 12C is configured to be connected to the first flexible wiring board 12A at a position farther from the second flexible wiring board 12B than the center of the first flexible wiring board 12A is in the first direction D1. Therefore, it is possible to improve the efficiency of arranging the third flexible wiring board 12C.

### [Modifications of First Embodiment]

The first embodiment described above can be implemented with the following modifications.

### [Edge]

- The edge 11E may not necessarily have the first notch 11EN1 and the second notch 11EN2. In this case, the first connection terminal CP1 is connected to the first bonding terminal 12AP and the first electrode terminal 11AP. Further, the second connection terminal CP2 is connected to the second bonding terminal 12BP and the second electrode terminal 11BP. Accordingly, the following effects can be obtained.

(1-7) Since the first connection terminal CP1 is connected to both the first bonding terminal 12AP and the first electrode terminal 11AP, a voltage applied to the first connection terminal CP1 is easily applied to the first electrode terminal 11AP via the first bonding terminal 12AP.

### [Third Flexible Wiring Board]

- The first power supply terminal CPS1 and the second power supply terminal CPS2 may not necessarily face in the same direction. For example, the first power supply terminal CPS1 may face the first surface 12CS1 of the third flexible wiring board 12C, while the second power supply terminal CPS2 may face the second surface 12CS2 of the third flexible wiring board 12C.
- In the second direction D2, the length of each tooth included in the comb-like electrode portion CP11 may be less than or equal to the sum of the length of each respective tooth included in the first comb-like electrode portion 12AP2 and the length of each respective tooth included in the second comb-like electrode portion 12AP3. Also in this case, the comb-like electrode portion CP11 can overlap at least one of the first comb-like electrode portion 12AP2 and the second comb-like electrode portion 12AP3.
- The first connection terminal CP1 and the second connection terminal CP2 may not necessarily have a comb-like shape. For example, the first connection terminal CP1 and the second connection terminal CP2 may be strip-shaped metal thin films.

### [First Flexible Wiring Board and Second Flexible Wiring Board]

- The shape of the first flexible wiring board 12A may not necessarily be the same as the shape of the second flexible wiring board 12B. Also in this case, both the first flexible wiring board 12A and the second flexible wiring board 12B may have a shape extending in the first direction D1.
- The first bonding terminal 12AP and the second bonding terminal 12BP may not necessarily include a comb-like electrode portion. In this case, the first bonding terminal 12AP and the second bonding terminal 12BP may be strip-shaped metal thin films.

### [Light Control Sheet]

- The first transparent conductive sheet 11A may include other functional layers such as a UV shielding layer, an infrared shielding layer, an alignment layer, an adhesive layer and a protective layer. The second transparent conductive sheet 11B may include other functional layers such as a UV shielding layer, an infrared shielding layer, an alignment layer, an adhesive layer and a protective layer.
- The light control sheet 11 is not limited to a rectangular shape, and may have a geometric shape such as a polygonal shape other than a rectangular shape, a circular shape or an elliptical shape, or may have an irregular shape other than a geometric shape. The light control sheet 11 is not limited to a two-dimensional flat surface, and may have a curved surface such as a cylindrical, spherical or wavy surface.

### [Second Embodiment]

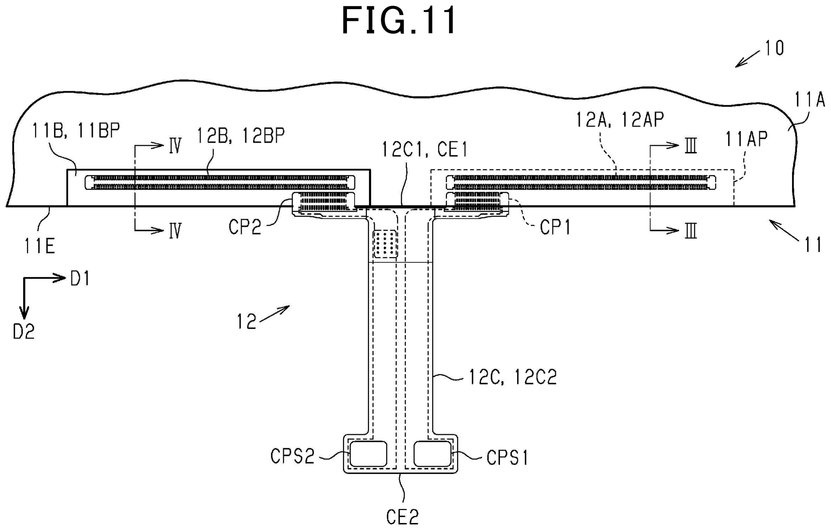

With reference to Figs. 11 to 13, a second embodiment of a flexible wiring board unit and a light control unit will be described. The second embodiment differs from the first embodiment mainly in the object to which the first connection terminal is bonded and the object to which the second connection terminal is bonded. Therefore, in the following description, the difference between the second embodiment and the first embodiment will be described in detail, omitting specific description of the components common to the second embodiment and the first embodiment by designating the same reference signs thereto as those of the first embodiment.

### [Light Control Unit]

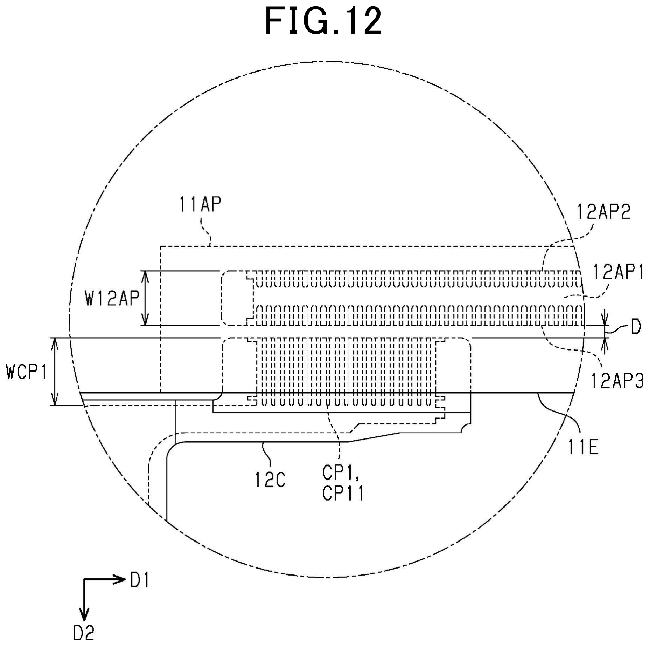

With reference to Figs. 11 and 12, a light control unit will be described.

As shown in Fig. 11, the first portion 12C1 is located at the first end CE1 in the second direction D2. The first portion 12C1 includes a first connection terminal CP1 and a second connection terminal CP2. The first connection terminal CP1 is located on the first end CE1 and connected to the first electrode terminal 11AP. The second connection terminal CP2 is located at the first end CE1. The second connection terminal CP2 is insulated from the first connection terminal CP1 and connected to the second electrode terminal 11BP. The first connection terminal CP1 and the second connection terminal CP2 are arranged at an interval in the first direction D1.

The first connection terminal CP1 of the third flexible wiring board 12C is configured to face, in the second direction D2, a portion of the first flexible wiring board 12A closer to the second flexible wiring board 12B than the center of the first flexible wiring board 12A is in the first direction D1. The third flexible wiring board 12C can be prevented from increasing in size compared to the case where the first connection terminal CP1 of the third flexible wiring board 12C is configured to face the first flexible wiring board 12A at a position farther from the second flexible wiring board 12B than the center of the first flexible wiring board 12A is in the first direction D1. Therefore, it is possible to improve the efficiency of arranging the third flexible wiring board 12C. From the viewpoint of improving the arrangement efficiency, as illustrated in Fig. 11, it is preferred that the first connection terminal CP1 is configured to face, in the second direction D2, an end of the first flexible wiring board 12A at a shorter distance from the second flexible wiring board 12B in the first direction D1.

The second connection terminal CP2 of the third flexible wiring board 12C is configured to face, in the second direction D2, a portion of the second flexible wiring board 12B closer to the first flexible wiring board 12A than the center of the second flexible wiring board 12B is in the first direction D1. The third flexible wiring board 12C can be prevented from increasing in size compared to the case where the second connection terminal CP2 of the third flexible wiring board 12C is configured to face the second flexible wiring board 12B at a position farther from the first flexible wiring board 12A than the center of the second flexible wiring board 12B is in the first direction D1. Therefore, it is possible to improve the efficiency of arranging the third flexible wiring board 12C. From the viewpoint of improving the arrangement efficiency, as illustrated in Fig. 11, it is preferred that the second connection terminal CP2 is configured to face, in the second direction D2, an end of the second flexible wiring board 12B at a shorter distance from the first flexible wiring board 12A in the first direction D1.

The cross-sectional structure taken along the line III-III shown in Fig. 11 is the same as the cross-sectional structure shown in Fig. 3 referred to above. Further, the cross-sectional structure taken along the line IV-IV shown in Fig. 11 is the same as the cross-sectional structure shown in Fig. 4 referred to above.

Fig. 12 shows an enlarged view of a part of the first bonding terminal 12AP and the first connection terminal CP1 located away from the first bonding terminal 12AP. In the flexible wiring board unit 12, the position of the second bonding terminal 12BP is different from the position of the first bonding terminal 12AP, while the structure of the second bonding terminal 12BP is the same as the structure of the first bonding terminal 12AP. Further, in the third flexible wiring board 12C, the position of the second connection terminal CP2 is different from the position of the first connection terminal CP1, while the structure of the second connection terminal CP2 is the same as the structure of the first connection terminal CP1. Therefore, in the following description, the structure of the first bonding terminal 12AP and the structure of the first connection terminal CP1 will be described in detail, but the structure of the second bonding terminal 12BP and the structure of the second connection terminal CP2 will not be described.

Since the first flexible wiring board 12A shown in Fig. 12 has the same structure as the first flexible wiring board 12A of the first embodiment, a conductive adhesive used when connecting the first bonding terminal 12AP to the first electrode terminal 11AP can easily spread in the first direction D1 through the main body portion 12AP1 of the first bonding terminal 12AP. Therefore, it is easy to apply the adhesive to the first bonding terminal 12AP, ensuring conductivity between the first bonding terminal 12AP and the first electrode terminal 11AP.

The first connection terminal CP1 includes a comb-like electrode portion CP11. The comb-like electrode portion CP11 has a comb-like shape with a series of teeth extending in the second direction D2. In the example shown in Fig. 12, the plurality of teeth included in the comb-like electrode portion CP11 are arranged at equal intervals in the first direction D1.

In the example shown in Fig. 12, in the first direction D1, the distance between the teeth of the comb-like electrode portion CP11 is equal to the distance between the teeth of the first comb-like electrode portion 12AP2 and the distance between the teeth of the second comb-like electrode portion 12AP3. The first connection terminal CP1 may be aligned with the first bonding terminal 12AP such that each tooth included in the first connection terminal CP1, each tooth included in the first comb-like electrode portion 12AP2, and each tooth included in the second comb-like electrode portion 12AP3 are aligned in the same straight line.

In the second direction D2, a width W12AP of the first bonding terminal 12AP is smaller than a width WCP1 of the first connection terminal CP1. Accordingly, the first electrode terminal 11AP can be prevented from increasing in width in the second direction D2 compared to the case where the width W12AP of the first bonding terminal 12AP is greater than or equal to the width WCP1 of the first connection terminal CP1.

A distance D between the first bonding terminal 12AP and the first connection terminal CP1 in the second direction D2 can be set according to the area of the light control sheet 11, the voltage value applied to the light control sheet 11, the resistance value of the light control sheet 11, the distance between the first connection terminal CP1 and the second connection terminal CP2, and the like. For example, the smaller the distance between the first connection terminal CP1 and the second connection terminal CP2, the more likely power concentration will occur between the first connection terminal CP1 and the second connection terminal CP2, so the distance D is preferably set to be a small value. The distance D may be smaller than the distance between the first connection terminal CP1 and the second connection terminal CP2, preferably 1/10 or less, more preferably 1/50 or less, and even more preferably 1/100 or less of the distance between the first connection terminal CP1 and the second connection terminal CP2.

In the first direction D1, the position of the end of the first bonding terminal 12AP at a shorter distance from the second flexible wiring board 12B substantially coincides with the position of the end of the first connection terminal CP1 at a shorter distance from the second flexible wiring board 12B. As a result, a current easily flows from the first connection terminal CP1 toward the end of the first bonding terminal 12AP at a shorter distance from the second flexible wiring board 12B, and a current easily flows from the end of the first bonding terminal 12AP at a shorter distance from the second flexible wiring board 12B toward the end at a farther distance from the second flexible wiring board 12B.

### [Flexible Wiring Board Unit]

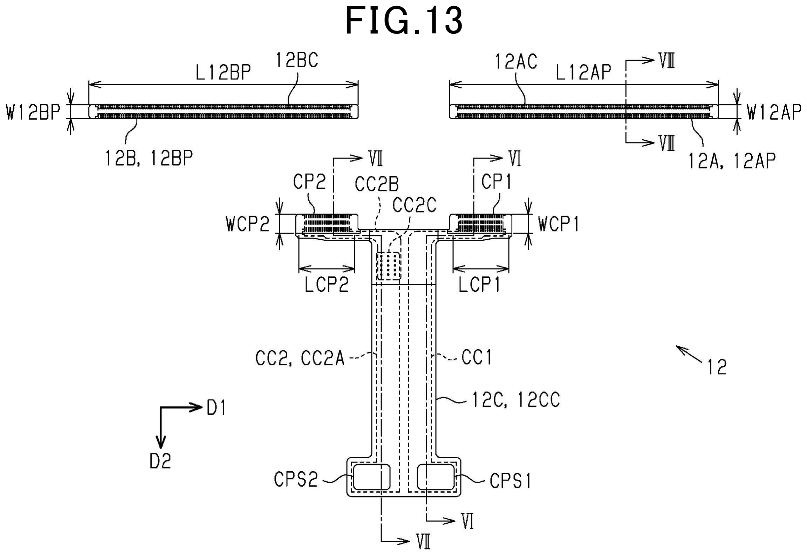

With reference to Fig. 13, the flexible wiring board unit 12 will be described.

As shown in Fig. 13, the flexible wiring board unit 12 includes the first flexible wiring board 12A, the second flexible wiring board 12B and the third flexible wiring board 12C. In the present embodiment, the first flexible wiring board 12A has the same shape as the shape of the second flexible wiring board 12B. Therefore, it is possible to reduce the number of types of flexible wiring boards constituting the flexible wiring board unit 12 compared to the case where the first flexible wiring board 12A has a shape different from that of the second flexible wiring board 12B. Therefore, the burden required for producing the flexible wiring board unit 12 can be reduced. In the following description, the shape of the first flexible wiring board 12A will be described, and the description of the shape of the second flexible wiring board 12B will be omitted.

The first flexible wiring board 12A has a length L12AP in the first direction D1 and a width W12AP in the second direction D2. The length L12AP of the first flexible wiring board 12A is greater than the width W12AP of the first flexible wiring board 12A. The first connection terminal CP1 of the third flexible wiring board 12C has a length LCP1 in the first direction D1 and a width WCP1 of the second direction D2. The second connection terminal CP2 of the third flexible wiring board 12C has a length LCP2 in the first direction D1 and a width WCP2 in the first direction D1. The width WCP1 of the first connection terminal CP1 is equal to the width WCP1 of the second connection terminal CP2, and the length LCP1 of the first connection terminal CP1 is equal to the length LCP2 of the second connection terminal CP2. The lengths LCP1 and LCP2 of the respective connection terminals CP1 and CP2 are greater than the widths WCP1 and WCP2 of the respective connection terminals CP1 and CP2.

The second flexible wiring board 12B has a length L12BP in the first direction D1 and a width W12BP in the second direction D2. The length L12BP of the second flexible wiring board 12B is equal to the length L12AP of the first flexible wiring board 12A, and the width W12BP of the second flexible wiring board 12B is equal to the width W12AP of the first flexible wiring board 12A.

The length LCP1 of the first connection terminal CP1 is smaller than the length L12AP of the first flexible wiring board 12A. The length LCP1 of the first connection terminal CP1 may be, for example, 50% or less of the length L12AP of the first flexible wiring board 12A, and preferably 30% or less. The width W12AP of the first flexible wiring board 12A is smaller than the width WCP1 of the first connection terminal CP1. The width W12AP of the first flexible wiring board 12A may be, for example, 50% or greater of the width WCP1 of the first connection terminal CP1, and preferably 80% or greater. The maximum width of the third flexible wiring board 12C in the first direction D1 is less than twice the length L12AP of the first flexible wiring board 12A, preferably 1.5 times or less the length L12AP, and more preferably less than or equal to the length L12AP.

The first flexible wiring board 12A includes a first covering portion 12AC that covers the first bonding terminal 12AP. The first covering portion 12AC is made of an insulator. The first covering portion 12AC may be made of, for example, a resin sheet. The first covering portion 12AC preferably has optical transparency, which allows the first bonding terminal 12AP to be seen from the outside of the first flexible wiring board 12A. The first covering portion 12AC externally exposes a portion of the first bonding terminal 12AP that is connected to the first electrode terminal 11AP. For example, the first covering portion 12AC externally exposes substantially the entire surface of the first bonding terminal 12AP on a side facing the first electrode terminal 11AP.

The second flexible wiring board 12B includes a second covering portion 12BC that covers the second bonding terminal 12BP, similarly to the first flexible wiring board 12A. The second covering portion 12BC is made of an insulator. The second covering portion 12BC may be made of, for example, a resin sheet. The second covering portion 12BC preferably has optical transparency, which allows the second bonding terminal 12BP to be seen from the outside of the second flexible wiring board 12B. The second covering portion 12BC externally exposes a portion of the second bonding terminal 12BP that is connected to the second electrode terminal 11BP. For example, the second covering portion 12BC externally exposes substantially the entire surface of the second bonding terminal 12BP on a side facing the second electrode terminal 11BP.

The cross-sectional structure taken along the line VI-VI shown in Fig. 13 is the same as the cross-sectional structure shown in Fig. 6 referred to above. Further, the cross-sectional structure taken along the line VII-VII shown in Fig. 13 is the same as the cross-sectional structure shown in Fig. 7 referred to above. Further, the cross-sectional structure of the first flexible wiring board 12A taken along the line VIII-VIII shown in Fig. 13 is the same as the cross-sectional structure shown in Fig. 8 referred to above.

As described above, according to the second embodiment of the flexible wiring board unit and the light control unit, the following effects can be obtained in addition to the (1-1), (1-4) and (1-5) described above.
(2-1) A conductive adhesive used when connecting the first bonding terminal 12AP to the first electrode terminal 11AP can easily spread in the first direction D1 through the main body portion 12AP1 of the first bonding terminal 12AP. Therefore, it is easy to apply the adhesive to the first bonding terminal 12AP.
(2-2) The first electrode terminal 11AP can be prevented from increasing in width in the second direction D2 compared to the case where the width W12AP of the first bonding terminal 12AP is greater than or equal to the width WCP1 of the first connection terminal CP1.
(2-3) The third flexible wiring board 12C can be prevented from increasing in size compared to the case where the first connection terminal CP1 of the third flexible wiring board 12C is configured to be connected to the first electrode terminal 11AP at a position farther from the second flexible wiring board 12B than the center of the first flexible wiring board 12A is in the first direction D1. Therefore, it is possible to improve the efficiency of arranging the third flexible wiring board 12C.

### [Modifications of Second Embodiment]

The second embodiment described above can be implemented with the following modifications.

### [Third Flexible Wiring Board]

- The first power supply terminal CPS1 and the second power supply terminal CPS2 may not necessarily face in the same direction. For example, the first power supply terminal CPS1 may face the first surface 12CS1 of the third flexible wiring board 12C, while the second power supply terminal CPS2 may face the second surface 12CS2 of the third flexible wiring board 12C.
- The first connection terminal CP1 and the second connection terminal CP2 may not necessarily have a comb-like shape. For example, the first connection terminal CP1 and the second connection terminal CP2 may be strip-shaped metal thin films.

### [First Flexible Wiring Board and Second Flexible Wiring Board]

- The shape of the first flexible wiring board 12A may not necessarily be the same as the shape of the second flexible wiring board 12B. Also in this case, both the first flexible wiring board 12A and the second flexible wiring board 12B may have a shape extending in the first direction D1.
- The first bonding terminal 12AP and the second bonding terminal 12BP may not necessarily include a comb-like electrode portion. In this case, the first bonding terminal 12AP and the second bonding terminal 12BP may be strip-shaped metal thin films.
- The width W12AP of the first bonding terminal 12AP may be greater than or equal to the width WCP1 of the first connection terminal CP1.

### [Light Control Sheet]

- The first transparent conductive sheet 11A may include other functional layers such as a UV shielding layer, an infrared shielding layer, an alignment layer, an adhesive layer and a protective layer. The second transparent conductive sheet 11B may include other functional layers such as a UV shielding layer, an infrared shielding layer, an alignment layer, an adhesive layer and a protective layer.
- The light control sheet 11 is not limited to a rectangular shape, and may have a geometric shape such as a polygonal shape other than a rectangular shape, a circular shape or an elliptical shape, or may have an irregular shape other than a geometric shape. The light control sheet 11 is not limited to a two-dimensional flat surface, and may have a curved surface such as a cylindrical, spherical or wavy surface.

## Claims

1. A flexible wiring board unit comprising:
a first flexible wiring board extending in a first direction;
a second flexible wiring board extending in the first direction; and
a third flexible wiring board extending in a second direction and configured to be connected to the first flexible wiring board and the second flexible wiring board, the second direction intersecting the first direction, wherein
the first flexible wiring board includes a first bonding terminal bonded to a first connection target,
the second flexible wiring board includes a second bonding terminal bonded to a second connection target,
the third flexible wiring board includes:
a first connection terminal located at a first end in the second direction, the first connection terminal being connected to the first bonding terminal;
a second connection terminal located at the first end in the second direction, the second connection terminal being insulated from the first connection terminal and connected to the second bonding terminal;
a first power supply terminal located at a second end in the second direction, the first power supply terminal being electrically connected to the first connection terminal; and
a second power supply terminal located at the second end in the second direction, the second power supply terminal being insulated from the first power supply terminal and electrically connected to the second connection terminal.

2. The flexible wiring board unit according to claim 1, wherein
the first bonding terminal includes:
a main body portion having a strip-shape extending in the first direction;
a first comb-like electrode portion located at a first end of the main body portion in the second direction, the first comb-like electrode portion having a comb-like shape with a plurality of teeth extending in the second direction; and
a second comb-like electrode portion located at a second end of the main body portion in the second direction, the second comb-like electrode portion having a comb-like shape with a plurality of teeth extending in the second direction, and
the first connection terminal includes a comb-like electrode portion having a comb-like shape with a plurality of teeth extending in the second direction and configured to be in contact with the first comb-like electrode portion and the second comb-like electrode portion.

3. The flexible wiring board unit according to claim 2, wherein,
in the second direction, the length of each tooth included in the comb-like electrode portion is longer than the sum of the length of each respective tooth included in the first comb-like electrode portion and the length of each respective tooth included in the second comb-like electrode portion.

4. The flexible wiring board unit according to any one of claims 1 to 3, wherein
the first flexible wiring board has the same shape as that of the second flexible wiring board.

5. The flexible wiring board unit according to any one of claims 1 to 3, wherein
the third flexible wiring board has a first surface, and a second surface facing away from the first surface in a thickness direction of the third flexible wiring board,
the first connection terminal, the first power supply terminal and the second power supply terminal face the first surface, and
the second connection terminal faces the second surface.

6. The flexible wiring board unit according to any one of claims 1 to 3, wherein
the first connection terminal of the third flexible wiring board is configured to be connected to a portion of the first flexible wiring board closer to the second flexible wiring board than a center of the first flexible wiring board is in the first direction.

7. A light control unit comprising:
the flexible wiring board unit according to any one of claims 1 to 3; and
a light control sheet, the light control sheet including:
a first transparent conductive sheet including a first transparent electrode layer including a first electrode terminal;
a second transparent conductive sheet including a second transparent electrode layer including a second electrode terminal; and
a light control layer disposed between the first transparent conductive sheet and the second transparent conductive sheet, wherein
the first electrode terminal and the second electrode terminal are arranged in the first direction at respective edges of the light control sheet extending in the first direction,
the first bonding terminal is electrically conductively bonded to the first electrode terminal,
the second bonding terminal is electrically conductively bonded to the second electrode terminal, and
the first connection terminal and the second connection terminal are connected to an external power supply.

8. The light control unit according to claim 7, wherein
the first connection terminal is connected to the first bonding terminal and the first electrode terminal.

9. A flexible wiring board unit comprising:
a first flexible wiring board extending in a first direction;
a second flexible wiring board extending in the first direction; and
a third flexible wiring board extending in a second direction and located away from the first flexible wiring board and the second flexible wiring board, the second direction intersecting the first direction, wherein
the first flexible wiring board includes a first bonding terminal bonded to a first connection target,
the second flexible wiring board includes a second bonding terminal bonded to a second connection target,
the third flexible wiring board includes:
a first connection terminal located at a first end in the second direction, the first connection terminal being bonded to the first connection target;
a second connection terminal located at the first end in the second direction, the second connection terminal being insulated from the first connection terminal and bonded to the second connection target;
a first power supply terminal located at a second end in the second direction, the first power supply terminal being electrically connected to the first connection terminal; and
a second power supply terminal located at the second end in the second direction, the second power supply terminal being insulated from the first power supply terminal and electrically connected to the second connection terminal.

10. The flexible wiring board unit according to claim 9, wherein
the first bonding terminal includes:
a main body portion having a strip-shape extending in the first direction;
a first comb-like electrode portion located at a first end of the main body portion in the second direction, the first comb-like electrode portion having a comb-like shape with a plurality of teeth extending in the second direction; and
a second comb-like electrode portion located at a second end of the main body portion in the second direction, the second comb-like electrode portion having a comb-like shape with a plurality of teeth extending in the second direction.

11. The flexible wiring board unit according to claim 9 or 10, wherein
in the second direction, the first bonding terminal has a width smaller than a width of the first connection terminal.

12. The flexible wiring board unit according to claim 9 or 10, wherein
the first flexible wiring board has the same shape as that of the second flexible wiring board.

13. The flexible wiring board unit according to claim 9 or 10, wherein
the third flexible wiring board has a first surface, and a second surface facing away from the first surface in a thickness direction of the third flexible wiring board,
the first connection terminal, the first power supply terminal and the second power supply terminal face the first surface, and
the second connection terminal faces the second surface.

14. The flexible wiring board unit according to claim 9 or 10, wherein
the first connection terminal of the third flexible wiring board faces, in the second direction, a portion of the first flexible wiring board closer to the second flexible wiring board than a center of the first flexible wiring board is in the first direction.

15. A light control unit comprising:
the flexible wiring board unit according to claim 9 or 10; and
a light control sheet, the light control sheet including:
a first transparent conductive sheet including a first transparent electrode layer including a first electrode terminal;
a second transparent conductive sheet including a second transparent electrode layer including a second electrode terminal; and
a light control layer disposed between the first transparent conductive sheet and the second transparent conductive sheet, wherein
the first electrode terminal and the second electrode terminal are arranged in the first direction at respective edges of the light control sheet extending in the first direction,
the first bonding terminal is electrically conductively bonded to the first electrode terminal,
the second bonding terminal is electrically conductively bonded to the second electrode terminal,
the first connection terminal is located away from the first bonding terminal, and electrically conductively bonded to the first electrode terminal in a state in which the first bonding terminal is located between the light control layer and the first connection terminal in the second direction,
the second connection terminal is located away from the second bonding terminal, and electrically conductively bonded to the second electrode terminal in a state in which the second bonding terminal is located between the light control layer and the second connection terminal in the second direction, and
the first connection terminal and the second connection terminal are connected to an external power supply.
